# EUROPÄISCHE PATENTSCHRIFT

(11) **EP 1 187 250 B1**
(45) Veröffentlichungstag und Bekanntmachung des Hinweises auf die Patenterteilung: **11.01.2006**
(21) Anmeldenummer: 01116972.9
(22) Anmeldetag: 12.07.2001
(51) Int. Cl.: H01P 1/38

(54) **Mikrowellenanordnung**
Microwave device
Dispositif hyperfréquence

(30) Priorität: 13.07.2000 DE 10034028
(43) Veröffentlichungstag der Anmeldung: 13.03.2002
(73) Patentinhaber: Muegge Electronic GmbH, 64385 Reichelsheim (DE)
(72) Erfinder: Muegge, Horst, 64385 Reichelsheim (DE)
(74) Vertreter: Gornott, Dietmar

(56) Entgegenhaltungen:
- DE-A- 2 260 863
- US-A- 3 085 212
- US-A- 4 697 158
- US-A- 5 724 010

## Beschreibung

Die Erfindung betrifft eine Mikrowellenanordnung mit einer Koppeleinrichtung für eine Mikrowellenquelle, einem Ausgang, einem Zirkulator und einer Last zur Dämpfung von über den Ausgang zurücklaufenden Mikrowellen.

Mikrowellen, die zur Erzeugung von Plasma benutzt werden, werden von dem Mikrowellengenerator häufig über Hohlleiter zu den in den Behandlungskammern angebrachten Antennen geleitet. Da bei derartigen Anlagen ein Abschluß mit dem Wellenwiderstand der Hohlleiter nicht gewährleistet sein kann, ist es erforderlich, die zurücklaufenden Wellen vom Mikrowellensender fernzuhalten.

Dazu sind bei bekannten Anordnungen Zirkulatoren vorgesehen, welche die zurücklaufenden Mikrowellen in eine Wasserlast leiten. Beispiele für solche Zirkulatoren sind in US 3,085,212 und US 5,724,010 beschrieben, wobei jeweils drei Ein-/Ausgänge zur Verbindung mit einer Mikrowellenquelle, einer Last und einem die Mikrowellen weiterleitenden System vorgesehen sind.

Die erfindungsgemäße Mikrowellenanordnung ist dadurch gekennzeichnet, daß in einem Block aus leitendem Werkstoff eine erste Kammer zur Einkopplung der Mikrowellen, eine zweite Kammer für den Zirkulator und für die Last eine dritte Kammer, in welcher ein Wasserschlauch aus mikrowellen-transparentem Material schleifenförmig verlegt ist, angeordnet sind, daß die erste mit der zweiten und die zweite mit der dritten Kammer und mit dem Ausgang über je einen Kanal verbunden sind und daß die Kanäle durch zentrische Lagerung von Leitern als Koaxialleitungen ausgebildet sind.

Die erfindungsgemäße Mikrowellenanordnung ermöglicht eine äußerst kompakte Anlage, wobei je nach Bedarf mehrere erfindungsgemäße Anordnungen zur Versorgung von mehreren Plasmaerzeugungssystemen oder anderen Mikrowellengeräten, beispielsweise Wärmeeinrichtungen, eingesetzt werden können. So kann beispielsweise die größte Ausdehnung des Blocks kleiner als 200 mm für Mikrowellen im 2,45-GHz-Bereich gewählt werden. Für andere Frequenzen, beispielsweise 915 MHz, ist die erfindungsgemäße Anordnung entsprechend größer auszuführen. Der Ausgang liegt bereits als Koaxialleitung vor, so daß Antennen unmittelbar angeschlossen werden können.

Eine vorteilhafte Ausgestaltung der Einkopplung der von der Mikrowellenquelle, vorzugsweise einem Magnetron, erzeugten Mikrowellen ist bei einer anderen Ausgestaltung dadurch möglich, daß der die erste mit der zweiten Kammer verbindende Leiter in die erste Kammer hineinragt und mit einer senkrecht zum Leiter verlaufenden Antenne versehen ist.

Eine vorteilhafte Einkopplung der zurücklaufenden Mikrowellen in die Last kann bei der erfindungsgemäßen Anordnung dadurch vorgesehen sein, daß der die zweite mit der dritten Kammer verbindende Leiter in die dritte Kammer hineinragt und eine Antenne bildet. Dabei ist vorzugsweise vorgesehen, daß die Form des in die dritte Kammer hineinragenden Teils des Leiters an die Impedanzverhältnisse in der dritten Kammer angepaßt ist.

Vorzugsweise ist die dritte Kammer zylinderförmig. Eine bei der erfindungsgemäßen Mikrowellenanordnung verwendete Last - auch kalorimetrische Last genannt - dient dazu, hochfrequente Schwingungsenergie in Wärme umzuwandeln. Die Wärme wird in einer umlaufenden Flüssigkeit absorbiert und abgeführt. Dabei kann auch die Leistung ermittelt werden als Produkt aus der Durchflußmenge, dem Temperaturanstieg und der spezifischen Wärme der Flüssigkeit, vorzugsweise Wasser.

Eine einfache Herstellung und Montage der erfindungsgemäßen Mikrowellenanordnung ist bei einer anderen vorteilhaften Ausgestaltung dadurch möglich, daß der Block derart zweigeteilt ist, daß mindestens die zweite Kammer und die Kanäle hälftig in je einen Teilblock fallen.

Ferner ist eine einfache Halterung der für den Zirkulator erforderlichen Permanentmagnete dadurch möglich, daß der Block auf beiden Seiten neben der zweiten Kammer außen Aussparungen für je einen Permanentmagneten enthält.

An sich sind für die erfindungsgemäße Mikrowellenanordnung verschiedene Werkstoffe geeignet. Wegen des geringen Gewichts und der guten Leitfähigkeit ist vorzugsweise vorgesehen, daß der Block aus Aluminium besteht.

Bei der erfindungsgemäßen Anordnung kann auch zum Messen der Mikrowellenenergie beim Prüfen von Mikrowellensystemen in einem Deckel der dritten Kammer eine Steckvorrichtung zur Auskopplung eines Teils der Mikrowellenenergie zu Meßzwecken vorgesehen sein.

Ausführungsbeispiele der Erfindung sind in der Zeichnung anhand mehrerer Figuren dargestellt und in der nachfolgenden Beschreibung näher erläutert. Es zeigt:
- Fig. 1: eine Ansicht eines ersten Ausführungsbeispiels,
- Fig. 2: eine Ansicht des ersten Ausführungsbeispiels bei entferntem oberen Teilblock und
- Fig. 3: eine Detailansicht des Zirkulators.

Gleiche Teile sind in den Figuren mit gleichen Bezugszeichen versehen.

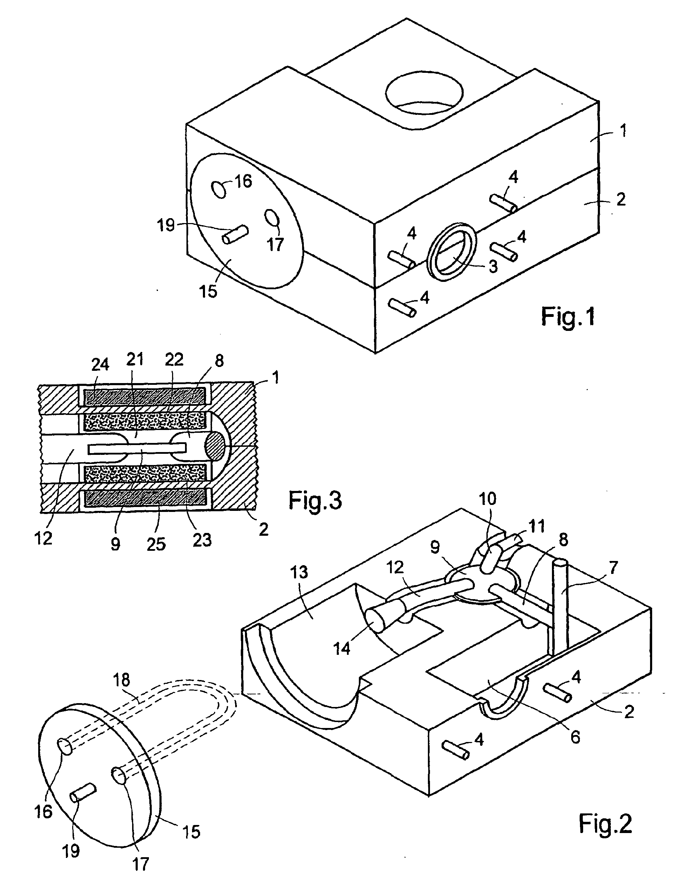

Das Ausführungsbeispiel nach den Figuren 1 bis 3 besteht aus einem zweigeteilten Block 1, 2 mit einer Öffnung 3 und vier Stehbolzen 4 zur Montage eines nicht dargestellten Magnetrons. Anstelle der Stehbolzen 4 stehen dem Fachmann auch andere Befestigungsmittel zur Verfügung. Hinter der Öffnung 3 befindet sich die erste Kammer 6, die zur Einkopplung der Mikrowellen dient und in die eine Antenne 7 einer ersten Koaxialleitung 8 hineinragt. Die erste Koaxialleitung stellt den ersten Port eines Zirkulators 9 dar, der außerdem einen zweiten Port, der über eine Koaxialleitung 10 mit dem Ausgang 11 verbunden ist, und einen dritten Port aufweist, der über eine weitere Koaxialleitung 12 an eine Kammer 13 angeschlossen ist und in Form einer Antenne 14 in diese hineinragt. Die Kammer 13 dient als sogenannte Wasserlast und wird mit einem Deckel 15 verschlossen mit zwei Löchern 16, 17 durch die ein lediglich angedeuteter Wasserschlauch 18 durchgeführt wird, der in der Kammer 13 schleifenförmig verlegt ist. Ferner ist im Deckel 15 eine Steckvorrichtung 19 vorgesehen, über die ein Teil der Mikrowellenenergie zu Meßzwecken ausgekoppelt werden kann.

Da die Funktionsweise von Zirkulatoren an sich bekannt ist, wird im Zusammenhang mit der Erfindung lediglich erwähnt, daß Mikrowellen, die dem ersten Port zugeführt werden, den Zirkulator beim zweiten Port in Richtung auf den Ausgang 11 verlassen, daß vom Ausgang 11 kommende Mikrowellen zur Antenne 14 geleitet werden und daß Mikrowellen von der Antenne 14 zum ersten Port gelangen, jedoch wegen der hohen Dämpfung der Wasserlast praktisch nicht auftreten.

Fig. 3 zeigt in Form einer Schnittdarstellung Einzelheiten des Zirkulators mit der Scheibe 9 und den Leitern bzw. Ports 8, 12. Innerhalb der für den Zirkulator vorgesehenen Kammer 21 befinden sich zwei Ferrit-Scheiben 22, 23, die von Permanentmagneten 24, 25 magnetisiert werden. Die Permanentmagnete 24, 25 befinden sich außerhalb des Blocks, damit sie von den Mikrowellen nicht entmagnetisiert werden. Die Wandstärke der Teilblöcke ist jedoch im Bereich des Zirkulators gegenüber den anderen Bereichen stark verringert, damit die Permanentmagnete 24, 25 möglichst dicht an den Ferrit-Scheiben 22, 23 liegen.

## Patentansprüche

1. Mikrowellenanordnung mit einer Koppeleinrichtung für eine Mikrowellenquelle, einem Ausgang, einem Zirkulator und einer Last zur Dämpfung von über den Ausgang zurücklaufenden Mikrowellen, **dadurch gekennzeichnet, daß** in einem Block (1, 2) aus leitendem Werkstoff eine erste Kammer (6) zur Einkopplung der Mikrowellen, eine zweite Kammer (21) für den Zirkulator (9) und für die Last eine dritte Kammer (13), in welcher ein Wasserschlauch (18) aus mikrowellen-transparentem Material schleifenförmig verlegt ist, angeordnet sind, daß die erste mit der zweiten und die zweite mit der dritten Kammer und mit dem Ausgang über je einen Kanal verbunden sind und daß die Kanäle durch zentrische Lagerung von Leitern (8, 10, 12) als Koaxialleitungen ausgebildet sind.

2. Mikrowellenanordnung nach Anspruch 1, **dadurch gekennzeichnet, daß** der die erste mit der zweiten Kammer verbindende Leiter (8) in die erste Kammer (6) hineinragt und mit einer senkrecht zum Leiter (8) verlaufenden Antenne (7) versehen ist.

3. Mikrowellenanordnung nach einem der vorhergehenden Ansprüche, **dadurch gekennzeichnet, daß** der die zweite mit der dritten Kammer verbindende Leiter (12) in die dritte Kammer (13) hineinragt und eine Antenne (14) bildet.

4. Mikrowellenanordnung nach Anspruch 3, **dadurch gekennzeichnet, daß** die Form des in die dritte Kammer hineinragenden Teils (14) des Leiters (12) an die Impedanzverhältnisse in der dritten Kammer angepaßt ist.

5. Mikrowellenanordnung nach einem der vorhergehenden Ansprüche, **dadurch gekennzeichnet, daß** die dritte Kammer (13) zylinderförmig ist.

6. Mikrowellenanordnung nach einem der vorhergehenden Ansprüche, **dadurch gekennzeichnet, daß** der Block (1, 2) derart zweigeteilt ist, daß mindestens die zweite Kammer (21) und die Kanäle hälftig in je einen Teilblock (1, 2) fallen.

7. Mikrowellenanordnung nach einem der vorhergehenden Ansprüche, **dadurch gekennzeichnet, daß** der Block (1, 2) auf beiden Seiten neben der zweiten Kammer (21) außen Aussparungen für je einen Permanentmagneten (24, 25) enthält.

8. Mikrowellenanordnung nach einem der vorhergehenden Ansprüche, **dadurch gekennzeichnet, daß** der Block (1, 2) aus Aluminium besteht.

9. Mikrowellenanordnung nach einem der vorhergehenden Ansprüche, **dadurch gekennzeichnet, daß** in einem Deckel (15) der dritten Kammer (13) eine Steckvorrichtung (19) zur Auskopplung eines Teils der Mikrowellenenergie zu Meßzwecken vorgesehen ist.

## Claims

1. Microwave device with a coupling device for a microwave source, an output, a circulator and a load for damping microwaves running back through the output, **characterised by** the fact that a first chamber (6) for coupling the microwaves, a second chamber (21) for the circulator (9) and a third chamber (13) for the load, in which a water pipe (18) made of microwave transparent material is laid in the shape of a loop, are arranged in a block (1, 2) made of conductive material so that the first chamber is connected with the second and the second with the third and the output each through a channel and the channels are made by the concentric arrangement of conductors (8, 10, 12) as coaxial lines.

2. Microwave device according to claim 1, **characterised by** the fact that the conductor (8) connecting the first chamber with the second chamber projects into the first chamber (6) and is provided with an antenna (7) running vertically to the conductor (8).

3. Microwave device according to one of the previous claims, **characterised by** the fact that the conductor (12) connecting the second chamber to the third chamber projects into the third chamber (13) and forms an antenna (14).

4. Microwave device according to claim 3, **characterised by** the fact that the shape of the part (14) of the conductor (12) projecting into the third chamber is adapted to the impedance conditions in the third chamber.

5. Microwave device according to one of the previous claims, **characterised by** the fact that the third chamber (13) is in the shape of a cylinder.

6. Microwave device according to one of the previous claims, **characterised by** the fact that the block (1, 2) is made of two parts in such a way that at least the second chamber (21) and the channels fall half into each part block (1, 2).

7. Microwave device according to one of the previous claims, **characterised by** the fact that the block (1, 2) contains recesses outside for a permanent magnet (24, 25) on both sides near the second chamber (21).

8. Microwave device according to one of the previous claims, **characterised by** the fact that the block (1, 2) is made of aluminium.

9. Microwave device according to one of the previous claims, **characterised by** the fact that a coupler (19) for uncoupling part of the microwave energy for measuring purposes is provided in a cover (15) of the third chamber (13).

## Revendications

1. Dispositif à micro-ondes comprenant un dispositif de couplage pour une source de micro-ondes, une sortie, un circulateur et une charge pour affaiblir des micro-ondes retournant par la sortie,
**caractérisé en ce qu'**
un bloc (1, 2) en matériau conducteur loge une première chambre (6) pour l'injection des micro-ondes, une deuxième chambre (21) pour le circulateur (9), et pour la charge une troisième chambre (13) dans laquelle un tuyau flexible à eau (18) en matériau transparent aux micro-ondes est installé en forme de boucle, la première chambre étant reliée à la deuxième alors que la deuxième est reliée à la troisième et à la sortie par chaque fois un canal, les canaux étant formés par logement centré de conducteurs (8, 10, 12) en tant que lignes coaxiales.

2. Dispositif à micro-ondes selon la revendication 1,
**caractérisé en ce que**
le conducteur (8) reliant la première à la deuxième chambre péntère dans la première chambre (6) et est muni d'une antenne (7) s'étendant perpendiculairement au conducteur (8).

3. Dispositif à micro-ondes selon l'une quelconque des revendications précédentes,
**caractérisé en ce que**
le conducteur (12) reliant la deuxième à la troisième chambre pénètre dans la troisième chambre (13) et forme une antenne (14).

4. Dispositif à micro-ondes selon la revendication 3,
**caractérisé en ce que**
la forme de la partie (14) du conducteur (12) saillant dans la troisième chambre est adaptée aux conditions d'impédance dans la troisième chambre.

5. Dispositif à micro-ondes selon l'une quelconque des revendications précédentes,
**caractérisé en ce que**
la troisième chambre (13) présente une forme cylindrique.

6. Dispositif à micro-ondes selon l'une quelconque des revendications précédentes,
**caractérisé en ce que**
le bloc (1, 2) est séparé en deux parties de telle sorte qu'au moins la deuxième chambre (21) et les canaux se situent pour moitié dans respectivement un bloc partiel (1, 2).

7. Dispositif à micro-ondes selon l'une quelconque des revendications précédentes,
**caractérisé en ce que**
le bloc (1, 2) comprend sur les deux faces à côté de la deuxième chambre (21) des évidements extérieurs pour respectivement un aimant permanent (24, 25).

8. Dispositif à micro-ondes selon l'une quelconque des revendications précédentes,
**caractérisé en ce que**
le bloc (1, 2) est réalisé en aluminium.

9. Dispositif à micro-ondes selon l'une quelconque des revendications précédentes,
**caractérisé en ce que**
dans un couvercle (15) de la troisième chambre (13) un dispositif à fiche (19) est prévu pour l'éjection d'une partie de l'énergie des micro-ondes à des fins de mesure.
